# EUROPEAN PATENT SPECIFICATION

(11) **EP 4 407 077 B1**
(45) Date of publication and mention of the grant of the patent: **09.12.2026**
(21) Application number: 22872512.3
(22) Date of filing: 30.06.2022
(51) Int. Cl.: C30B 29/36, C30B 29/06, C30B 25/02, C30B 25/18, C30B 29/40, C30B 25/16, C30B 25/20, C30B 25/10

(54) **METHOD FOR PRODUCING HETEROEPITAXIAL WAFER**
VERFAHREN ZUR HERSTELLUNG EINES HETEROEPITAKTISCHEN WAFERS
PROCÉDÉ DE PRODUCTION DE TRANCHE HÉTÉROÉPITAXIALE

(30) Priority: 21.09.2021 JP 2021153418
(43) Date of publication of application: 31.07.2024
(73) Proprietor: Shin-Etsu Handotai Co., Ltd., Tokyo 100-0004 (JP)
(72) Inventor: MATSUBARA, Toshiki, Nishishirakawa-gun, Fukushima 961-8061 (JP); SUZUKI, Atsushi, Nishishirakawa-gun, Fukushima 961-8061 (JP); ABE, Tatsuo, Nishishirakawa-gun, Fukushima 961-8061 (JP); TSUCHIYA, Keitaro, Annaka-shi, Gunma 379-0196 (JP); SUZUKI, Yukari, Annaka-shi, Gunma 379-0196 (JP); OHTSUKI, Tsuyoshi, Nishishirakawa-gun, Fukushima 961-8061 (JP)
(74) Representative: Mooser, Sebastian Thomas
(86) International application number: PCT/JP2022/026315
(87) International publication number: WO 2023/047755

(56) References cited:
- JP-A- 2002 234 799
- JP-A- 2003 212 694
- JP-A- 2003 212 694
- JP-A- 2004 103 671
- JP-A- 2005 347 666
- JP-A- 2005 347 666
- JP-A- 2006 036 613
- JP-A- 2006 253 617
- JP-A- 2012 204 602
- JP-A- 2016 092 399
- US-A1- 2002 102 862
- KOMIYAMA J ET AL: "Schottky diode characteristics of 3C-SiC grown on a Si substrate by vapor phase epitaxy", JOURNAL OF CRYSTAL GROWTH, ELSEVIER, AMSTERDAM, NL, vol. 275, no. 1-2, 15 February 2005 (2005-02-15), pages e1001 - e1006, XP027849702, ISSN: 0022-0248, [retrieved on 20050215]

## Description

### TECHNICAL FIELD

The present invention relates to a method for producing a heteroepitaxial wafer heteroepitaxially growing a 3C-SiC single crystal film on a single crystal silicon substrate.

### BACKGROUND ART

SiC has a wider bandgap of 2.2 to 3.3 eV, compared with a bandgap of Si of 1.1 eV, which gives a high dielectric breakdown strength and high thermal conductivity, making it a promising material as a semiconductor material for various semiconductor devices such as power devices and high-frequency devices.

In addition, the utilization of SiC as a platform for gallium nitride (GaN) growth has progressed (for example, Patent Document 1 and Non Patent Document 1); on the other hand, a mainstream of SiC wafers is wafers having small diameters, thus enlargement of the diameters for the power devices and the high-frequency devices are required. If 3C-SiC single crystal films with excellent quality can be formed on large diameter substrates, in addition to utilizing the 3C-SiC single crystal films thereof, a production of heteroepitaxial wafers having a large diameter and an excellent quality GaN layer is enabled. Non Patent Document 2 discloses the preparation of a 3C-SiC thin film through heteroepitaxial growth of 3C-SiC on a silicon substrate by the use of methylsilane single source as an intermediate buffer layer. The active layer growth of 3C-SiC was achieved using silane and propane sources.

Hence, as a method for enlargement, epitaxial growth on a silicon substrate having excellent compatibility with device processes, has been studied (for example, Patent Documents 1 and 2).

These Patent Documents disclose that a 3C-SiC single crystal film can be grown on a silicon substrate, and the 3C-SiC single crystal film can be grown on a large diameter substrate such as a substrate having a 300 mm diameter, depending on a selection of a reactor.

The formation of the 3C-SiC single crystal film in these Patent Documents is characterized by introducing two types of raw material gases, a gas containing a carbon source precursor and a gas containing a silicon source precursor, together with a carrier gas into the reactor, and then decomposing these raw material gases by high-temperature treatment (up to 1200°C) or by a combination of high-temperature treatment and plasma treatment for growing.

When such a film-forming is performed with two types of raw material gases being flowed simultaneously, it is extremely difficult to control differences in thermal stability or diffusion coefficients of respective types of gases to grow the 3C-SiC single crystal film having excellent quality, and a problem is caused in which a range of applicable process conditions are narrowed (e.g., the process conditions need to be such that the decomposed raw material gases do not react in the gas phase due to failure of epitaxial growth, and contaminate the reactor). Moreover, the need for high-temperature processing has a problem with making affinity lower with existing processes (when the diameter is enlarged, such as 300 mm, it is desirable to form films at as low temperature as possible to avoid anti-slip property and other problems). Furthermore, the more types of raw material gases used, the higher the cost of equipment and ancillary facilities, and the more safety issues (in particular, gases used as silicon sources are generally highly reactive) arise; thus, fewer raw material gases used are better.

As an example of a 3C-SiC single crystal film growth on a silicon substrate, Patent Document 3 discloses the use of a single crystal silicon substrate of plane orientation (110) as a single crystal silicon substrate to reduce a lattice mismatch between silicon and SiC to a smaller extent. This is advantageous for the lattice mismatch, but when production of the heteroepitaxial wafer is considered, the limiting plane orientation is not desirable. Although the formation of a 3C-SiC single crystal layer containing hydrogen is also disclosed at the same time, it is supposed that hydrogen is easily released during the heating process at an epitaxial growth sequence, and it is desired that the condition does not depend on the amount of hydrogen.

In addition, although an off angle of a single crystal silicon substrate is referred to in Patent Document 4, it is carbonization by propane and subsequent growth by propane and silane gas, which is still disadvantageous for epitaxial growth due to the increase of raw material gas types as well.

Moreover, Patent Document 5 discloses a method for growing a 3C-SiC single crystal layer on a single crystal silicon substrate having plane orientation (111) and a diameter of smaller than 8 inches (200 mm) using monomethylsilane as a raw material gas. However, a formation condition, in this case, is that pressure in a chamber is on condition of 2×10⁻⁴ to 3×10⁻⁴ Torr (0.02 to 0.03 Pa) for 5 to 12 hours after the temperature of a single crystal silicon substrate reaches 1050 to 1100°C of the formation condition. The formation of the 3C-SiC single crystal layer is performed under the extremely low-pressure condition, which results in a problem of low formation speed.
Patent Document 6 discloses a SiC semiconductor capable of making a β-SiC single crystal thin film of high quality with good crystallinity.
A β-SiC single-crystal thin film with a thickness of 1 µm or more is formed on a Si single-crystal substrate. It is described to consist of a first SiC layer with a thickness of 3 to 20 nm containing amorphous material, and a second SiC layer with a thickness of 10 to 50 nm composed of numerous β-SiC growth nuclei, sequentially interposed.

### CITATION LIST

### PATENT LITERATURE

Patent Document 1: JP 2018-522412 A
Patent Document 2: JP 2021-020819 A
Patent Document 3: JP 2006-253617 A
Patent Document 4: JP 2008-184361 A
Patent Document 5: JP 2017-039622 A
Patent Document 6: JP 2005 347666 A

### NON PATENT LITERATURE

Non Patent Document 1: Japanese Journal of Applied Physics 53, 05FL09 (2014)
Non Patent Document 2: Komiyama J et al: "Schottky diode characteristics of 3C-SiC grown on a Si substrate by vapor phase epitaxy", JOURNAL OF CRYSTAL GROWTH, ELSEVIER, AMSTERDAM, NL, vol. 275, no. 1-2, 15 February 2005 (2005-02-15), pages e1001-e1006, XP027849702, ISSN: 0022-0248

### SUMMARY OF INVENTION

### TECHNICAL PROBLEM

The present invention has been made in view of the above-described problem. An object of the present invention is to provide a method for producing a heteroepitaxial wafer capable of heteroepitaxially growing a 3C-SiC single crystal film with excellent quality efficiently on a single crystal silicon substrate.

### SOLUTION TO PROBLEM

To achieve the object, the present invention provides a method for producing a heteroepitaxial wafer heteroepitaxially growing a 3C-SiC single crystal film on a single crystal silicon substrate, the method comprising: with using a reduced-pressure CVD apparatus,
a first step of removing a native oxide film on a surface of the single crystal silicon substrate having plane orientation (111) by hydrogen baking;
a second step of nucleation of SiC on the single crystal silicon substrate on condition of pressure of 13332 Pa or lower and a temperature of 300°C or higher and 950°C or lower and a third step of forming the 3C-SiC single crystal film by growing a SiC single crystal on condition of pressure of 133 Pa or higher and 13332 Pa or lower and a temperature of 800°C or higher and lower than 1200°C, while supplying a source gas containing carbon and silicon into the reduced-pressure CVD apparatus,
wherein at least an initial stage of the third step is performed on condition of pressure of 1333 Pa or lower, thereby forming a vacancy directly under the 3C-SiC single crystal film, and
the source gas is trimethylsilane.

In this way, by removing the native oxide film on the surface of the single crystal silicon substrate in the first step, the nucleation of SiC becomes possible in the second step.

In addition, by combining pressure and temperature conditions that facilitate the nucleation of SiC in the second step and pressure and temperature conditions that facilitate the growth of the SiC single crystal in the third step, it is possible to efficiently produce the objective heteroepitaxial wafer with 3C-SiC single crystal film thickness having the excellent quality.

Moreover, making the pressure 13332 Pa (100 Torr) or lower can prevent reactions of secondary or higher orders, such as a reaction of reaction active species with a raw material gas in the gas phase, thus ensuring the heteroepitaxial growth. Thereby, polycrystallization of 3C-SiC can be prevented.

The source gas is trimethylsilane.

Such a raw material gas can supply both Si and C by a single gas; thus, a step of nucleation, which is called carbonization before 3C-SiC single crystal film growth, is also unnecessary, in which a carbon atom is attached to the surface of the single crystal silicon substrate by gas containing carbon source precursor. Then, the film formation of a 3C-SiC single crystal is enabled with a very simple condition.

Moreover, compared with a method, in which the carbon atom is first attached on the surface of the single crystal silicon substrate by a gas containing carbon source precursor for nucleation and then the 3C-SiC single crystal film is formed using a gas containing carbon source precursor and a gas containing silicon source precursor; the reaction active species in the gas phase are more controllable, and the heteroepitaxial growth is more reliable, thereby forming a thick 3C-SiC single crystal film much easier without stopping the growth of 3C-SiC single crystals.

In addition, the first step can be performed on condition of a temperature of 1000°C or higher and 1200°C or lower.

By using such a temperature condition, the native oxide film on the surface of the single crystal silicon substrate can be removed more efficiently, and the occurrence of slip dislocations can be prevented.

Moreover, at least an initial stage of the third step is performed on condition of pressure of 1333 Pa or lower, thereby forming a vacancy directly under the 3C-SiC single crystal film.

In this way, by making the pressure 1333 Pa (10 Torr) or lower at the third step, the vacancy can be formed in a silicon layer (single crystal silicon substrate) directly under the 3C-SiC single crystal film while growing the 3C-SiC single crystal film. The presence of the vacancy not only relaxes a lattice mismatch between 3C-SiC and silicon but also relaxes the stress of an entire epitaxial layer, thus enabling more reliable formation of the 3C-SiC single crystal film without crystal defects even for a thick 3C-SiC single crystal film.

Furthermore, the third step can be performed with one or more of pressure and temperature higher than the condition of the second step.

The third step can be performed on the condition identical to the condition of the second step, but if the condition is described above, a growth rate of the 3C-SiC single crystal film can be much faster in the third step. Thus, the formation can be performed efficiently even when forming a thick 3C-SiC single crystal film.

In this event, the third step can be performed on condition of a temperature of 1000°C or higher and lower than 1200°C.

Under this growth condition, the heteroepitaxial growth can be controlled by transport of the supply gas and is not restricted by the plane orientation of the single crystal silicon substrate. Moreover, forming a layer containing hydrogen is unnecessary, and the 3C-SiC single crystal film can be grown more reliably. Furthermore, the 3C-SiC single crystal film can be more easily formed on a single silicon substrate, for example, with a large diameter of 300 mm.

In addition, one or more of pressure and temperature can be raised higher during the third step.

With this method, it is possible to form the vacancy directly under the 3C-SiC single crystal film on the conditions with the pressure of, for example, 1333 Pa (10 Torr) or lower in an initial stage of the third step and then increase the pressure to accelerate the film-formation rate. Similarly, the temperature can be raised to a higher temperature to accelerate the formation rate from the middle of the step.

In this case, the second step and the third step can be performed on condition of gradually raising a temperature from a range from 300°C or higher to 950°C or lower to the range from 1000°C or higher to lower than 1200°C, thereby performing the nucleation of SiC and the formation of a 3C-SiC single crystal film following the nucleation of SiC in succession.

In this way, the heteroepitaxial growth can be controlled by transport of the supply gas and not restricted by the plane orientation of the single crystal silicon substrate, and containing hydrogen is unnecessary. Moreover, the 3C-SiC single crystal film can be more easily formed on a single silicon substrate having a large diameter.

Then, the temperature rise can be at a rate of temperature rise of 0.5°C/sec or faster and 2°C/sec or slower.

With such a rate of temperature rise, controlling the temperature can be performed more reliably. In addition, uniform nucleation of SiC can be performed, and the generation of defects during heteroepitaxial growth can be effectively prevented.

Moreover, a GaN layer can be formed on a surface of the formed 3C-SiC single crystal film by further growing GaN thereon, or a Si layer can be formed on the surface of the formed 3C-SiC single crystal film by further growing Si thereon.

The 3C-SiC single crystal film grown as described above has a flat surface. Thus, the GaN layer or the Si layer can be further heteroepitaxial grown on the surface of the 3C-SiC single crystal film.

### ADVANTAGEOUS EFFECTS OF INVENTION

According to the inventive method for producing the heteroepitaxial wafer, the heteroepitaxial wafer, in which the 3C-SiC single crystal layer having excellent quality is directly formed on the single crystal silicon substrate, can be efficiently provided by a simple producing process. Furthermore, the method for producing the heteroepitaxial wafer having the GaN layer or the Si layer directly formed on the 3C-SiC single crystal film can be provided.

### BRIEF DESCRIPTION OF DRAWINGS

FIG. 1 is a graph showing an example of a growth sequence in the first embodiment.
FIG. 2 is a graph showing an example of a growth sequence in the second embodiment.
FIG. 3 is a graph showing an example of a growth sequence in the third embodiment.
FIG. 4 is a graph showing a result of In plane XRD analysis of SiC on Si (111) grown in Example 1 (the first embodiment).
FIG. 5 is a measurement diagram showing a cross-sectional TEM image of SiC on Si grown at a pressure of 133 Pa (1 Torr) in Example 1 (the first embodiment).
FIG. 6 is a graph showing a result of In plane XRD analysis of SiC on Si (111) grown in Example 2 (the second embodiment).
FIG. 7 is a measurement diagram showing a cross-sectional TEM image of SiC on Si grown at a pressure of 133 Pa (1 Torr) in Example 2 (the second embodiment).
FIG. 8 is a graph showing a result of In plane XRD analysis of SiC on Si (111) grown in Example 3 (the third embodiment).
FIG. 9 is a graph showing a cross-sectional TEM image of SiC on Si grown at a pressure of 133 Pa (1 Torr) in Example 3 (the third embodiment).

### DESCRIPTION OF EMBODIMENTS

Hereinafter, embodiments of the present invention will be described with reference to the drawings. However, the present invention is not limited thereto.

As described above, a method for producing a heteroepitaxial wafer, in which a 3C-SiC single crystal film can be formed on a single crystal silicon substrate, has been required. Thereupon, the present inventors have earnestly studied and found out a method in which the heteroepitaxial wafer is produced, with using a reduced-pressure CVD apparatus, in addition to hydrogen baking of removing a native oxide film on a surface of the single crystal silicon substrate having plane orientation (111) (the first step), by combining predetermined pressure and temperature conditions that facilitate the nucleation of SiC [Pressure: 13332 Pa or lower, Temperature: 300°C or higher and 950°C or lower] (the second step) and predetermined pressure and temperature conditions that facilitate the growth of the SiC single crystal [Pressure: 133 Pa or higher and 13332 Pa or lower, Temperature: 800°C or higher and lower than 1200°C] (the third step), while supplying a source gas (containing carbon and silicon) according to the claims. Moreover, the present inventors have found out that the method can efficiently produce the 3C-SiC single crystal film having the excellent quality. Based on these findings, the present invention has been completed.

Hereinafter, each step is described, referring to various specific examples.

### (First Embodiment)

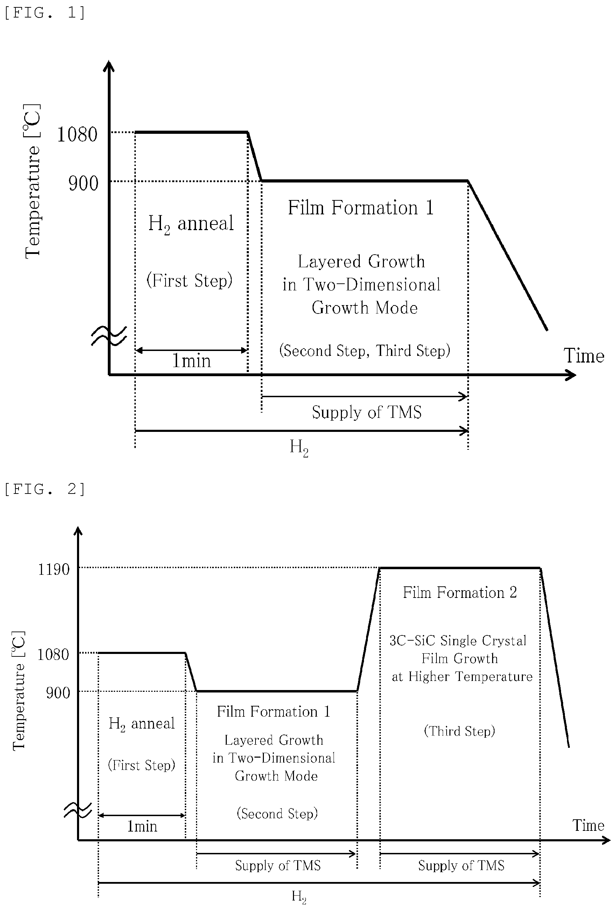

FIG. 1 shows an example of a growth sequence of the first embodiment. Hydrogen baking as a first step (hereinafter also referred to as H₂ anneal), a nucleation step of SiC as a second step, and a growth step of SiC single crystal as a third step (formation step of 3C-SiC single crystal film) are performed in sequence. Hereinafter, each step is described.

### <First Step>

To begin with, a single crystal silicon substrate having plane orientation (111) is placed in a reduced-pressure CVD apparatus (hereinafter also referred to as RP-CVD apparatus), hydrogen gas is introduced, and then a native oxide film on the surface is removed by H₂ anneal. When an oxide film remains, the nucleation of SiC on the single crystal silicon substrate becomes impossible. H₂ anneal, in this case, is preferably on condition of, for example, a temperature of 1000°C or higher and 1200°C or lower. Making the temperature 1000°C or higher can prevent long processing time to prevent residual native oxide film, thus being efficient. Meanwhile, making the temperature 1200°C or lower can effectively prevent a generation of a slip dislocation due to high temperature. However, the pressure or time of H₂ anneal at the time has no particular restriction as long as the native oxide film can be removed.

In the example shown in FIG. 1, H₂ anneal is performed at 1080°C for one minute. Meanwhile, the introduction of the hydrogen gas can be continued even after this first step as well as the second and third steps (carrier gas).

### <Second Step>

Then, the single crystal silicon substrate is set to a predetermined pressure and temperature, and source gas containing carbon and silicon is introduced as a raw material gas for SiC into the RP-CVD apparatus, and then the nucleation of SiC is performed. Trimethylsilane (TMS) is introduced as the source gas. It is simpler and easier to control than using a plurality of types of gases, and more reliable formation of the 3C-SiC single crystal film is possible. Further, since C has smaller atoms and vaporizes more easily than Si, trimethylsilane is easier for a condition setting when considering raw material efficiency.

Such an introduction of the source gas is performed in this second step and the following third step.

Moreover, this nucleation of SiC can be performed on the surface of the single crystal silicon substrate when the pressure is 13332 Pa (100 Torr) or lower, and the temperature is 300°C or higher and 950°C or lower.

In the nucleation step of SiC, when a temperature condition is higher than 950°C, the reaction between the single crystal silicon substrate and the raw material gas proceeds, and the nucleation of SiC on the surface of the single crystal silicon substrate cannot be formed. On the other hand, when a temperature is lower than 300°C, the temperature is too low, thereby making efficient nucleation of SiC impossible.

Additionally, considering the third step described next at this point, if the temperature is lower than 800°C during the third step, heteroepitaxial growth of SiC does not proceed. Thereupon, from the time of the second step, for example, the temperature of nucleation of SiC can be set preferably between 800°C or higher and 950°C and less, more preferably between 850°C or higher and 900°C or lower. By making the temperature of the second step 800°C or higher and 950°C or lower, the temperature ranges for the nucleation step of SiC (second step) and the following third step, which is the formation of the 3C-SiC single crystal film, can be overlapped, in particular, these second and third steps can be performed under the same temperature condition.

Moreover, the pressure is kept at 13332 Pa (100 Torr) or lower, which is efficient because it prevents secondary or higher-order reactions, such as the reaction of the reaction active species with raw material gas in the gas phase. The lower pressure limit is not particularly limited but can be 133 Pa (1 Torr), for example. Moreover, the pressure, as in the temperature, can be the same conditions in the second and third steps.

In the example shown in FIG. 1, this second step and the following third step are performed under the same conditions, the same pressure, and the same retention temperature (900°C).

### <Third Step>

In addition, the formation step of 3C-SiC single crystal film, which is the third step, is performed on condition of the pressure of 133 Pa or higher and 13332 Pa (100 Torr) or lower and the temperature of 800°C or higher and lower than 1200°C. With such a condition, the SiC single crystal can be efficiently grown, thereby forming the 3C-SiC single crystal film.

Moreover, when the growth pressure exceeds 13332Pa, 3C-SiC formed is poly-crystallized. On the other hand, in the present invention, the pressure in the third step is made to be 13332 Pa (100 Torr) or lower, the secondary or higher-order reactions can be suppressed in the vapor phase as described above, and the 3C-SiC single crystal film can be formed reliably and efficiently. Furthermore, the pressure can be preferably 1333 Pa (10 Torr) or lower, and even 133 Pa (1 Torr) or lower; under these conditions, a vacancy is formed directly under the 3C-SiC single crystal film, thereby obtaining an effect to relax the stress of an entire heteroepitaxial layer. The lower pressure limit is not limited but can be 13.3 Pa (0.1 Torr), for example.

Furthermore, concerning the temperature, the SiC single crystal growth does not progress at lower than 800°C as described above; the slip dislocation may be generated at 1200°C or higher. Consequently, the temperature is 800°C or higher and lower than 1200°C as described above.

In the example shown in FIG. 1, the second and third steps are on the same conditions, as described above, the nucleation of SiC and the formation of the 3C-SiC single crystal film are performed in succession.

Since the film thickness at this time depends on the pressure and temperature, the film-formation time can be determined appropriately based on the pressure and temperature conditions determined to achieve the desired film thickness.

In this case, the film thickness of the 3C-SiC single crystal film can be formed within a thin film of about 2 nm to a thick film of several µm, for example.

In addition, a layered growth in two-dimensional growth mode shown in FIG. 1 is a layer by layer epitaxial growth.

When GaN is grown on the 3C-SiC single crystal film grown in such a way, a heteroepitaxial wafer having a GaN layer with excellent quality can be obtained.

In this event, GaN growth is performed for film-formation by MOCVD using organometallic materials such as trimethylgallium and trimethylammonium to grow GaN of about three µm.

Furthermore, by growing Si on the 3C-SiC single crystal film grown in this way, it is possible to obtain a substrate with a high-quality Si epitaxial layer. With this structure, in the case of power devices such as IGBTs, for example, the 3C-SiC single crystal film serves as a breakdown-voltage-retaining layer in the IGBT. The dielectric breakdown electric field strength of silicon is 0.3 MV/cm, while the dielectric breakdown electric field strength of 3C-SiC is 3 MV/cm, thus that of 3C-SiC is ten times larger. That is, the same performance can be obtained with one-tenth of the thickness of a breakdown-voltage-retaining layer of a conventional silicon IGBT. Needless to say, it is not necessary to form the breakdown-voltage-retaining layer only with the 3C-SiC single crystal film, but a combination of SiC and Si is also sufficient. SiC is grown to a predetermined thickness in this way, and then the Si epitaxial layer is grown thereon. In conventional SiC devices, a gate insulator film is formed using SiC, which has reliability problems. However, silicon is grown in this structure, and then a gate insulator film is grown using this silicon; thus, the same gate reliability as the conventional silicon IGBT can be ensured. Moreover, a thickness of the silicon layer in this case can be determined discretionarily as long as the layer is thicker than the required gate structure.

### (Second Embodiment)

FIG. 2 shows an example of a growth sequence of the second embodiment.

### <First Step: H₂ Anneal>

To begin with, a single crystal silicon substrate having plane orientation (111) is placed in an RP-CVD apparatus, and a native oxide film on the surface is removed by H₂ anneal. This can be done as in the first embodiment.

### <Second Step: Nucleation Step of SiC>

Then, as a nucleation step of SiC, the single crystal silicon substrate is set at a temperature of 300°C or higher and 950°C or lower, preferably 800°C or higher and 950°C or lower, more preferably 850°C or higher and 900°C or lower, and then trimethylsilane is introduced as a raw material gas for SiC. The time for nucleation can be five minutes, for example.

### <Third Step: Formation Step of 3C-SiC single crystal film>

Then, as a formation of the 3C-SiC single crystal film step, a temperature of the single crystal silicon substrate is raised to 1000°C or higher and lower than 1200°C by heating, and then trimethylsilane is introduced as a raw material gas of SiC.

The third step, which is this formation step of the 3C-SiC single crystal film, raises one or more of the pressure and the temperature higher than the second step which is the nucleation step of SiC, thereby facilitating growth at a high rate (change between steps). Moreover, raising one or more of the pressure and the temperature during the third step can facilitate growth at a high rate (change within a step). Only one of the above change between steps or change within a step can be made, or both can be made.

Then, the temperature in the third step can be made to 1000°C or higher and lower than 1200°C. In this case, heteroepitaxial growth can be controlled by transport of supplied gas. It is not restricted by a plane orientation of the single crystal silicon substrate, and a product having a large diameter, such as 300 mm, can be dealt with easily.

FIG. 2 shows an example of only performing the change between steps. The second step is performed by maintaining 900°C, and the third step is performed by maintaining 1190°C (the pressure is the same for the second and third steps, for example). However, not being limited thereto, for example, the second step can be carried out while maintaining at 900°C, then the introduction of trimethylsilane is stopped once, and then, as the third step, the introduction of trimethylsilane can be restarted and a temperature is maintained on condition at 900°C, or higher than 900°C and lower than 1190°C for a predetermined time, and then the temperature can be raised to 1190°C and maintained.

In addition, the growth in FIG. 2 is performed at a higher temperature (1190°C) than the first embodiment (900°C), the reason why the heteroepitaxial growth is possible even on the condition may be due to H₂ flow during the temperature rise and the effects of the H₂, or the effects of changing the temperature during growth (i.e., when transitioned from the second step to the third step) which changes growth mode. As shown in FIG. 2, the sequence in FIG. 2 also results in two-dimensional growth from nucleation.

In particular, the pressure is set to 1333 Pa (10 Torr) or lower, preferably 133 Pa (1 Torr) or lower, in the nucleation step of SiC and the initial stage of the formation step of 3C-SiC single crystal film to form a vacancy directly under the 3C-SiC single crystal film. Then, the pressure is changed to the condition higher than 1333Pa (10 Torr), thereby achieving both stress relaxation of the entire heteroepitaxial layer and efficient formation of the 3C-SiC single crystal film.

Then, by growing GaN or Si on the 3C-SiC single crystal film grown in this way, the substrate having a high-quality GaN epitaxial layer or Si epitaxial layer can be obtained.

### (Third Embodiment)

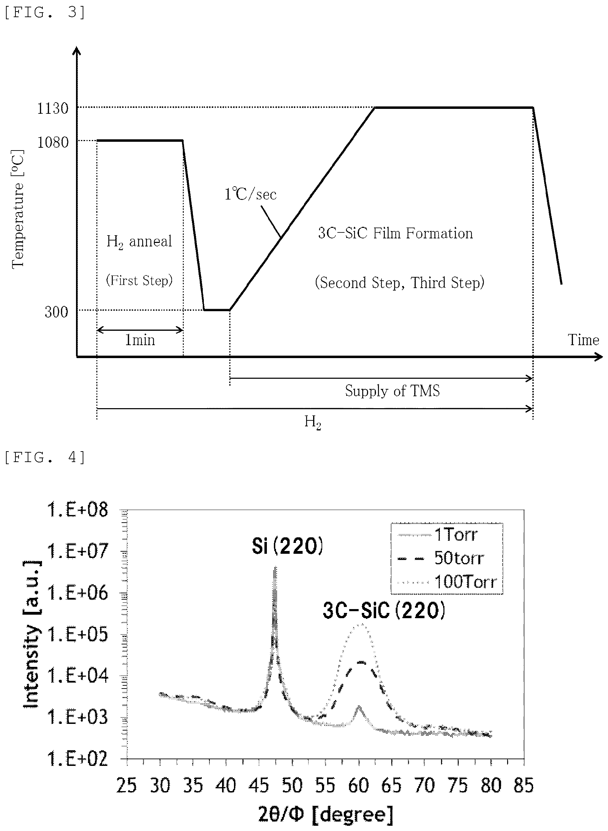

FIG. 3 shows an example of a growth sequence of the third embodiment.

### <First Step>

To begin with, a single crystal silicon substrate having plane orientation (111) is placed in an RP-CVD apparatus, and a native oxide film on the surface of the substrate is removed by H₂ anneal as on a similar condition in the first embodiment.

### <Second Step, Third Step>

Then, in order to perform the nucleation of SiC and subsequent formation of a 3C-SiC single crystal film in succession on the surface of the single crystal silicon substrate, a temperature is gradually raised from a range of 300°C or higher and 950°C or lower to a range of 1000°C or higher and lower than 1200°C, while introducing trimethylsilane as a raw material gas. In this way, the second step and third step can be performed consecutively in the course of raising the temperature.

A rate of temperature rise is preferably 0.5°C/sec or faster and 2°C/sec or slower, for example. The rate of temperature rise at this level is not too fast rate of temperature rise, thus, the deviation between the set temperature and the actual temperature can be effectively prevented, and the temperature control can be properly performed. Moreover, the rate of temperature rise is not too slow; thus, it can prevent facilitating a generation of ununiform nucleation due to a long transit time of a temperature zone for SiC nucleation or facilitating a generation of a defect during heteroepitaxial growth.

In this case, the temperature may be raised to a predetermined temperature within a range of 1000°C or higher and lower than 1200°C, then the growth may be stopped there, or the growth can be continued until a predetermined film thickness is achieved while maintaining at that temperature. Or, the growth may be stopped when the predetermined film thickness is achieved along with the rise in temperature, even if the temperature has reached 1000°C or higher but has not reached the predetermined temperature described above. A gradual acceleration of the forming rate of the film is enabled by growth with a continuously changing growth mode (changing from nucleation to two-dimensional growth) by growing with varying temperatures.

In FIG. **3****,** the temperature rises from 300°C to 1130°C at the rate of temperature rise of 1°C/sec, then is maintained at 1130°C intact for the predetermined time.

In particular, the pressure is set to 1333 Pa (10 Torr) or lower, preferably 133 Pa (1 Torr) or lower, in the nucleation step of SiC and the initial stage of the formation step of 3C-SiC single crystal film to form a vacancy directly under the 3C-SiC single crystal film. Then, the pressure is changed to the condition higher than 1333Pa (10 Torr), thereby achieving both stress relaxation of the entire heteroepitaxial layer and efficient formation of the 3C-SiC single crystal film.

Then, by growing GaN or Si on the 3C-SiC single crystal film grown in this way, the substrate having an excellent quality GaN epitaxial layer or Si epitaxial layer can be obtained.

### EXAMPLE

Hereinafter, the present invention will be specifically described with reference to Examples and Comparative Examples. However, the present invention is not limited thereto.

### (Example 1)

High-resistance single crystal silicon substrates having a diameter of 300 mm, plane orientation (111) and boron-doped were prepared, and wafers were placed on a susceptor in a reactor of an RP-CVD apparatus, and then H₂ anneal was performed at 1080°C for one minute (First Step).

Then, trimethylsilane gas was introduced at a growth temperature of 900°C and growth pressures of 133 Pa, 6666 Pa, and 13332 Pa (1 Torr, 50 Torr, and 100 Torr) to perform a nucleation step of SiC (Second Step) and a 3C-SiC single crystal film growth (Third Step). As a result of five minutes of growth, film thicknesses were 13 nm, 18 nm, and 31 nm, respectively.

Subsequently, when XRD (X-ray diffraction) spectra were confirmed in in-plane arrangement, peaks of 3C-SiC (220) parallel to Si (220) were successfully confirmed in either growth pressure conditions, as shown in a graph of XRD analysis results in FIG. 4, and growth of single crystal 3C-SiC films was confirmed.

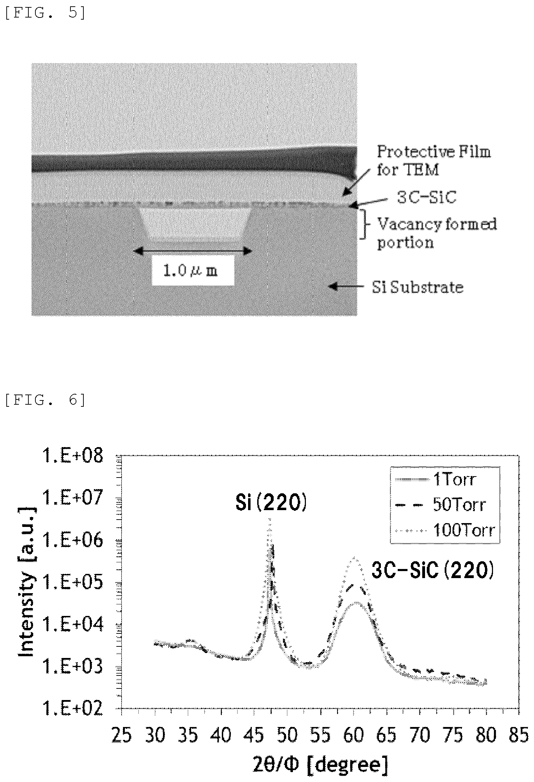

Moreover, FIG. 5 shows a cross-sectional TEM image when the growth pressure was 133 Pa (1 Torr). As a result, a formation of vacancy directly under a 3C-SiC single crystal layer was confirmed.

### (Example 2)

High-resistance single crystal silicon substrates having a diameter of 300 mm, plane orientation (111) and boron-doped were prepared, and wafers were placed on a susceptor in a reactor of an RP-CVD apparatus, and then H₂ anneal was performed at 1080°C for one minute (First Step).

Subsequently, trimethylsilane gas was introduced at a growth temperature of 900°C for five minutes as a second step (Nucleation Step of SiC).

Then, the growth temperature was raised to 1190°C, and trimethylsilane gas was introduced to grow 3C-SiC single crystal films as a third step (Formation Step of 3C-SiC single crystal film). The growth pressures here were uniformly 133 Pa, 6666 Pa, and 13332 Pa (1 Torr, 50 Torr, and 100 Torr). As a result of growth for one minute, film thicknesses were about 30 nm, 39 nm, and 45 nm, respectively.

After the film-formation, when XRD spectra were confirmed in in-plane arrangement, peaks of 3C-SiC (220) parallel to Si (220) were successfully confirmed in either growth pressure conditions, as shown in a graph of XRD analysis results in FIG. **6****,** and growth of single crystal 3C-SiC films were confirmed.

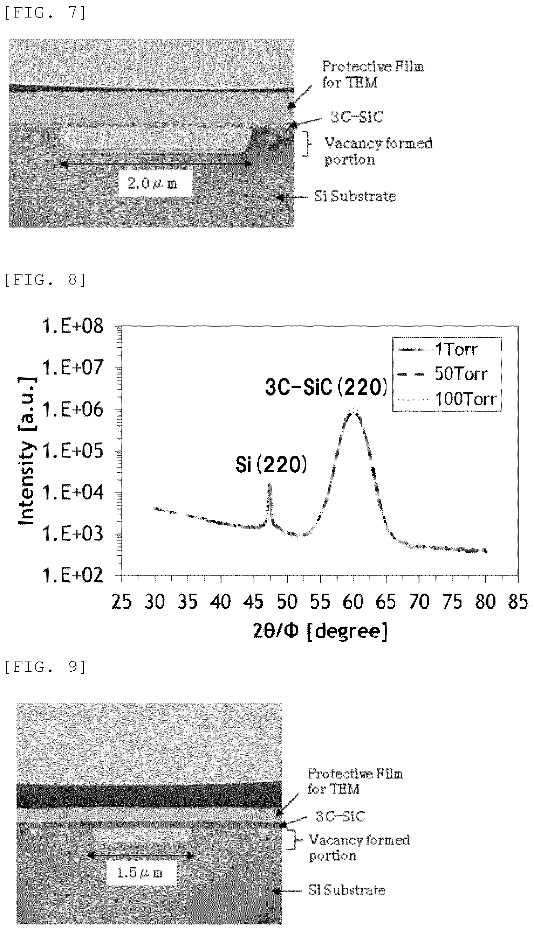

Moreover, FIG. 7 shows a cross-sectional TEM image when the growth pressure was 133 Pa (1 Torr). As a result, a formation of vacancy directly under a 3C-SiC single crystal layer was confirmed.

### (Example 3)

High-resistance single crystal silicon substrates having a diameter of 300 mm, plane orientation (111) and boron-doped were prepared, and wafers were placed on a susceptor in a reactor of an RP-CVD apparatus, and then H₂ anneal was performed at 1080°C for one minute (First Step) .

Subsequently, a temperature of a furnace was lowered to 300°C, then trimethylsilane gas was introduced while raising the temperature to 1130°C at a rate of temperature rise of 1°C/sec to perform a nucleation step of SiC (Second Step) and a subsequent formation step of 3C-SiC single crystal film (Third Step) in succession. The growth pressures here were uniformly 133 Pa, 6666 Pa, and 13332 Pa (1 Torr, 50 Torr, and 1 Torr). Moreover, after the temperature reached 1130°C, the temperature was held for 10 min, and 3C-SiC single crystal films were grown. As a result, film thicknesses were about 100 nm, 115 nm, and 120 nm, respectively.

After the formation, when XRD spectra were confirmed in in-plane arrangement, peaks of 3C-SiC (220) parallel to Si (220) were successfully confirmed in either growth pressure conditions, as shown in a graph of XRD analysis results in FIG. 8, and growth of the single crystal 3C-SiC films were confirmed.

Moreover, FIG. 9 shows a cross-sectional TEM image when the growth pressure was 133 Pa (1 Torr). As a result, a formation of vacancy directly under a 3C-SiC single crystal layer was confirmed.

### (Example 4)

High-resistance single crystal silicon substrates having a diameter of 300 mm, plane orientation (111) and boron-doped were prepared, and wafers were placed on a susceptor in a reactor of an RP-CVD apparatus, and then H₂ anneal was performed at 1080°C for one minute (First Step) .

Then, trimethylsilane gas was introduced at a growth temperature of 900°C and growth pressures of 13332 Pa (100 Torr) to perform a nucleation step of SiC (Second Step) and a 3C-SiC single crystal film growth (Third Step). In this case, an initial growth pressure was at 133 Pa (1 Torr) in the third step and raised to 13332 Pa (100 Torr) in the middle of the third step. As a result of five minutes of growth, a film thickness was 89 nm.

Subsequently, when XRD spectra were confirmed in in-plane arrangement, peaks of 3C-SiC (220) parallel to Si (220) were successfully confirmed, and the growth of single crystal 3C-SiC films was confirmed. In addition, from a cross-sectional TEM image in this instance, a formation of vacancy directly under a 3C-SiC single crystal layer was confirmed.

Meanwhile, when a growth rate, in which pressure was changed at 900°C, was investigated in another experiment, the growth rate at 133 Pa (1 Torr) was 0.04 nm/s, and the growth rate at 13332 Pa (100 Torr) was 0.14 nm/s, and thus it was confirmed that increasing the pressure in the middle of the step enabled to make a film thicker than a constant condition of 133 Pa (1 Torr).

### (Comparative Example 1)

A formation of 3C-SiC single crystal films was performed as in conditions of Example 1, except that a growth pressure of 3C-SiC (Second Step and Third Step) was 19998 Pa (150 Torr). As a result, film thicknesses were about 20 nm.

Subsequently, when XRD spectra were confirmed in in-plane arrangement, in addition to peaks of 3C-SiC (220) parallel to Si (220), peaks of 3C-SiC (111) and 3C-SiC (311) were confirmed, and the growth of polycrystalline 3C-SiC film was confirmed.

### (Comparative Example 2)

A formation of 3C-SiC single crystal films was performed as in conditions of Example 2, except that a growth pressure (Second Step and Third Step) of 3C-SiC was uniformly 19998 Pa (150 Torr). As a result, film thicknesses were about 50 nm.

When XRD spectra were confirmed in in-plane arrangement after the film-formation, in addition to peaks of 3C-SiC (220) parallel to Si (220), peaks of 3C-SiC (111) and 3C-SiC (311) were confirmed, and the growth of polycrystalline 3C-SiC films was confirmed.

### (Comparative Example 3)

A formation of 3C-SiC single crystal films was performed as in conditions of Example 3, except that a growth pressure of 3C-SiC (Second Step and Third Step) was 19998 Pa (150 Torr) uniformly. As a result, film thicknesses were about 130 nm.

When XRD spectra were confirmed in in-plane arrangement after the film-formation, in addition to peaks of 3C-SiC (220) parallel to Si (220), peaks of 3C-SiC (111) and 3C-SiC (311) were confirmed, and the growth of polycrystalline 3C-SiC films was confirmed.

### (Example 5)

Subsequently, 3C-SiC substrates grown by a method in Example 1 were placed in a MO-CVD apparatus, and an AlN buffer layer was formed at a growth temperature of 1100°C, and then GaN was grown thereon at 1190°C.

Then, when the rocking curve half widths of GaN were measured by XRD spectra in out of plane arrangement and were found to be 640, and then found that it was possible to grow a GaN layer having a film quality equal to or higher than one having the half width of 774 obtained when GaN was grown under the same conditions on a single crystal silicon substrate without a 3C-SiC epitaxial layer being formed.

### (Example 6)

A formation of 3C-SiC single crystal films was performed as in conditions of Example 1 in which a growth pressure was 13332 Pa (100 Torr), except that the growth temperature of the second step and third step was at 950°C. As a result, film thicknesses were about 33 nm.

Subsequently, when XRD spectra were confirmed in in-plane arrangement, peaks of 3C-SiC (220) parallel to Si (220) were successfully confirmed, and the growth of single crystal 3C-SiC films was confirmed.

### (Example 7)

A formation of 3C-SiC single crystal films was performed as in conditions of Example 2 in which a growth pressure was 13332 Pa (100 Torr), except that a growth temperature of the second step and third step were at 300°C and 800°C, respectively. As a result, a film thickness was about 29 nm.

Subsequently, when XRD spectra were confirmed in in-plane arrangement, peaks of 3C-SiC (220) parallel to Si (220) were successfully confirmed, and the growth of single crystal 3C-SiC films was confirmed.

### (Comparative Example 4)

A formation of 3C-SiC single crystal films was performed as in conditions of Example 2, except that a growth temperature of the second step was at 200°C or 1000°C. As a result, film thicknesses were about 2 nm or 4 nm, respectively.

Film thicknesses formed this way were extremely thin compared with those of Example 2 and significantly inefficient. This is considered as nucleation of SiC was insufficient due to too high or too low temperature in the second step, thus, very little heteroepitaxial growth was made in the third step.

### (Comparative Example 5)

A formation of 3C-SiC single crystal films was performed as in conditions of Example 2, except that a growth temperature of the third step was at 700°C or 1250°C. As a result, film thicknesses were about 7 nm or 50 nm, respectively.

As seen above, a film thickness in the case of 700°C was extremely thin compared with that of Example 2 and significantly inefficient. Moreover, a slip dislocation was generated at a temperature of 1250°C.

It should be noted that the present invention is not limited to the above-described embodiments. The embodiments are just examples.

## Claims

1. A method for producing a heteroepitaxial wafer heteroepitaxially growing a 3C-SiC single crystal film on a single crystal silicon substrate, the method comprising: with using a reduced-pressure CVD apparatus,
a first step of removing a native oxide film on a surface of the single crystal silicon substrate having plane orientation (111) by hydrogen baking;
a second step of nucleation of SiC on the single crystal silicon substrate on condition of pressure of 13332 Pa or lower and a temperature of 300°C or higher and 950°C or lower and a third step of forming the 3C-SiC single crystal film by growing a SiC single crystal on condition of pressure of 133 Pa or higher and 13332 Pa or lower and a temperature of 800°C or higher and lower than 1200°C, while supplying a source gas containing carbon and silicon into the reduced-pressure CVD apparatus,
wherein at least an initial stage of the third step is performed on condition of pressure of 1333 Pa or lower, thereby forming a vacancy directly under the 3C-SiC single crystal film, and
the source gas is trimethylsilane.

2. The method for producing a heteroepitaxial wafer according to claim 1, wherein
the first step is performed on condition of a temperature of 1000°C or higher and 1200°C or lower.

3. The method for producing a heteroepitaxial wafer according to claim 1 or 2, wherein
the second step is performed on condition of pressure of 133 Pa or higher and 1333 Pa or lower.

4. The method for producing a heteroepitaxial wafer according to any one of claims 1 to 3, wherein
the third step is performed with one or more of pressure and temperature higher than the condition of the second step.

5. The method for producing a heteroepitaxial wafer according to claim 4, wherein
the third step is performed on condition of a temperature of 1000°C or higher and lower than 1200°C.

6. The method for producing a heteroepitaxial wafer according to any one of claims 1 to 5, wherein
one or more of pressure and temperature are raised higher during the third step.

7. The method for producing a heteroepitaxial wafer according to claim 6, wherein
the second step and the third step are performed on condition of gradually raising a temperature from a range from 300°C or higher to 950°C or lower to the range from 1000°C or higher to lower than 1200°C, thereby performing the nucleation of SiC and the formation of a 3C-SiC single crystal film following the nucleation of SiC in succession.

8. The method for producing a heteroepitaxial wafer according to claim 7, wherein
the temperature rise is at a rate of temperature rise of 0.5°C/sec or faster and 2°C/sec or slower.

9. The method for producing a heteroepitaxial wafer according to any one of claims 1 to 8, wherein
a GaN layer is formed on a surface of the formed 3C-SiC single crystal film by further growing GaN thereon.

10. The method for producing a heteroepitaxial wafer according to any one of claims 1 to 8, wherein
a Si layer is formed on the surface of the formed 3C-SiC single crystal film by further growing Si thereon.

## Patentansprüche

1. Verfahren zur Herstellung eines heteroepitaktischen Wafers durch heteroepitaktisches Aufwachsen einer 3C-SiC-Einkristallschicht auf einem Einkristall-Siliziumsubstrat, wobei das Verfahren umfasst: unter Verwendung einer CVD-Anlage mit reduziertem Druck,
einen ersten Schritt des Entfernens einer nativen Oxidschicht auf einer Oberfläche des Einkristall-Siliziumsubstrats mit einer Ebenenorientierung (111) durch Wasserstoffausglühen;
einen zweiten Schritt der Keimbildung von SiC auf dem Einkristall-Siliziumsubstrat unter der Bedingung eines Drucks von 13.332 Pa oder weniger und einer Temperatur von 300 °C oder mehr und 950 °C oder weniger sowie einen dritten Schritt der Bildung der 3C-SiC-Einkristallschicht durch Aufwachsen eines SiC-Einkristalls unter der Bedingung eines Drucks von 133 Pa oder mehr und 13.332 Pa oder weniger und einer Temperatur von 800 °C oder mehr und weniger als 1.200 °C, während ein kohlenstoff- und siliziumhaltiges Ausgangsgas in die CVD-Anlage mit reduziertem Druck eingeleitet wird,
wobei zumindest eine Anfangsphase des dritten Schritts unter der Bedingung eines Drucks von 1.333 Pa oder weniger durchgeführt wird, wodurch direkt unterhalb der 3C-SiC-Einkristallschicht eine Leerstelle gebildet wird, und
das Ausgangsgas Trimethylsilan ist.

2. Verfahren zur Herstellung eines heteroepitaktischen Wafers nach Anspruch 1, wobei
der erste Schritt unter der Bedingung einer Temperatur von 1.000 °C oder höher und 1.200 °C oder niedriger durchgeführt wird.

3. Verfahren zur Herstellung eines heteroepitaktischen Wafers nach Anspruch 1 oder 2, wobei
der zweite Schritt unter der Bedingung eines Drucks von 133 Pa oder mehr und 1.333 Pa oder weniger durchgeführt wird.

4. Verfahren zur Herstellung eines heteroepitaktischen Wafers nach einem der Ansprüche 1 bis 3, wobei
der dritte Schritt bei einem gegenüber den Bedingungen des zweiten Schritts höheren Druck und/oder einer höheren Temperatur durchgeführt wird.

5. Verfahren zur Herstellung eines heteroepitaktischen Wafers nach Anspruch 4, wobei
der dritte Schritt unter der Bedingung einer Temperatur von 1.000 °C oder höher und unter 1.200 °C durchgeführt wird.

6. Verfahren zur Herstellung eines heteroepitaktischen Wafers nach einem der Ansprüche 1 bis 5, wobei
der Druck und/oder die Temperatur während des dritten Schritts erhöht werden.

7. Verfahren zur Herstellung eines heteroepitaktischen Wafers nach Anspruch 6, wobei
der zweite Schritt und der dritte Schritt unter der Bedingung durchgeführt werden, dass die Temperatur schrittweise von einem Bereich von 300 °C oder höher bis 950 °C oder niedriger auf den Bereich von 1.000 °C oder höher bis unter 1.200 °C erhöht wird, wodurch nacheinander die Keimbildung von SiC und die Bildung einer 3C-SiC-Einkristallschicht im Anschluss an die Keimbildung von SiC erfolgen.

8. Verfahren zur Herstellung eines heteroepitaktischen Wafers nach Anspruch 7, wobei
der Temperaturanstieg mit einer Temperaturanstiegsrate von 0,5 °C/s oder schneller und 2 °C/s oder langsamer erfolgt.

9. Verfahren zur Herstellung eines heteroepitaktischen Wafers nach einem der Ansprüche 1 bis 8, wobei
eine GaN-Schicht auf einer Oberfläche der gebildeten 3C-SiC-Einkristallschicht gebildet wird, indem GaN darauf weiter aufgewachsen wird.

10. Verfahren zur Herstellung eines heteroepitaktischen Wafers nach einem der Ansprüche 1 bis 8, wobei
eine Si-Schicht auf der Oberfläche der gebildeten 3C-SiC-Einkristallschicht gebildet wird, indem Si darauf weiter aufgewachsen wird.

## Revendications

1. Procédé de fabrication d'une tranche hétéroépitaxiale faisant croître de manière hétéroépitaxiale un film monocristallin de 3C-SiC sur un substrat de silicium monocristallin, le procédé comprenant: à l'aide d'un appareil CVD à pression réduite,
une première étape d'élimination d'un film d'oxyde natif sur une surface du substrat de silicium monocristallin présentant une orientation plane (111) par recuit par l'hydrogène;
une deuxième étape de nucléation du SiC sur le substrat de silicium monocristallin à une pression inférieure ou égale à 13332 Pa et à une température supérieure ou égale à 300°C et inférieure ou égale à 950°C, et une troisième étape de formation du film monocristallin de 3C-SiC par croissance d'un monocristal de SiC à une pression supérieure ou égale à 133 Pa et inférieure ou égale à 13332 Pa et à une température supérieure ou égale à 800°C et inférieure à 1200°C, tout en introduisant un gaz source contenant du carbone et du silicium dans l'appareil CVD à pression réduite,
dans lequel au moins une étape initiale de la troisième étape est réalisée à une pression inférieure ou égale à 1333 Pa, ce qui permet de former une lacune directement sous le film monocristallin de 3C-SiC, et
le gaz source est le triméthylsilane.

2. Procédé de fabrication d'une tranche hétéroépitaxiale selon la revendication 1, dans lequel
la première étape est réalisée à une température supérieure ou égale à 1000°C et inférieure ou égale à 1200°C.

3. Procédé de fabrication d'une tranche hétéroépitaxiale selon la revendication 1 ou 2, dans lequel
la deuxième étape est réalisée à une pression supérieure ou égale à 133 Pa et inférieure ou égale à 1333 Pa.

4. Procédé de fabrication d'une tranche hétéroépitaxiale selon l'une quelconque des revendications 1 à 3, dans lequel
la troisième étape est réalisée à une ou plusieurs parmi une pression et une température supérieures à celles de la deuxième étape.

5. Procédé de fabrication d'une tranche hétéroépitaxiale selon la revendication 4, dans lequel
la troisième étape est réalisée à une température supérieure ou égale à 1000°C et inférieure à 1200°C.

6. Procédé de fabrication d'une tranche hétéroépitaxiale selon l'une quelconque des revendications 1 à 5, dans lequel
au cours de la troisième étape, une ou plusieurs parmi une pression et température sont augmentées davantage.

7. Procédé de fabrication d'une tranche hétéroépitaxiale selon la revendication 6, dans lequel
La deuxième étape et la troisième étape sont réalisées par augmentation progressive d'une température allant d'une plage supérieure ou égale à 300°C à 950°C ou moins jusqu'à la plage supérieure ou égale à 1000°C à inférieure à 1200 °C, ce qui permet de procéder successivement à la nucléation du SiC et à la formation d'un film monocristallin de 3C-SiC à la suite de la nucléation de SiC.

8. Procédé de fabrication d'une tranche hétéroépitaxiale selon la revendication 7, dans lequel
l'augmentation de température s'effectue à une vitesse d'augmentation de température supérieure ou égale à 0,5°C/s et inférieure ou égale à 2°C/s.

9. Procédé de fabrication d'une tranche hétéroépitaxiale selon l'une quelconque des revendications 1 à 8, dans lequel
une couche de GaN est formée sur la surface du film monocristallin de 3C-SiC ainsi obtenu, en y faisant croître du GaN.

10. Procédé de fabrication d'une tranche hétéroépitaxiale selon l'une quelconque des revendications 1 à 8, dans lequel
une couche de GaN est formée sur la surface du film monocristallin de 3C-SiC ainsi obtenu, en y faisant croître davantage du Si.
